# EUROPÄISCHE PATENTSCHRIFT

(11) **EP 2 351 166 B1**
(45) Veröffentlichungstag und Bekanntmachung des Hinweises auf die Patenterteilung: **16.04.2014**
(21) Anmeldenummer: 09778881.4
(22) Anmeldetag: 30.09.2009
(51) Int. Cl.: H01L 23/00, H01R 4/02, H01R 43/02, H01R 12/59, H01R 12/62

(54) **VERFAHREN ZUM GLEICHZEITIGEN MECHANISCHEN UND ELEKTRISCHEN VERBINDEN VON ZWEI TEILEN**
METHOD FOR CONNECTING TWO PARTS MECHANICALLY AND ELECTRICALLY AT THE SAME TIME
PROCEDE DE RACCORDEMENT MECANIQUE ET ELECTRIQUE SIMULTANE DE DEUX PIECES

(30) Priorität: 30.09.2008 DE 102008050000
(43) Veröffentlichungstag der Anmeldung: 03.08.2011
(73) Patentinhaber: Fraunhofer-Gesellschaft zur Förderung der angewandten Forschung e.V., 80686 München (DE)
(72) Erfinder: LINZ, Torsten, 10115 Berlin (DE)
(74) Vertreter: Pfenning, Meinig & Partner GbR
(86) Internationale Anmeldenummer: PCT/EP2009/007273
(87) Internationale Veröffentlichungsnummer: WO 2010/037565

(56) Entgegenhaltungen:
- EP-A- 0 834 956
- WO-A-03/097289
- DE-A1- 19 618 104
- DE-A1- 19 723 241

## Beschreibung

Die Erfindung betrifft ein Verfahren nach dem Oberbegriff des Anspruchs 1. Ein solches Verfahren nach dem Oberbegriff des Anspruchs 1 ist aus der DE-A-197 23241 bekannt.

In elektronischen und elektrischen Systemen sind elektrische Leiter üblicherweise mit Ausnahme ihrer Kontaktstellen mit einer elektrischen Isolierung versehen, die gleichzeitig einen mechanischen oder chemischen Schutz bilden soll. Die Isolierungen können entsprechend der jeweiligen Anforderung aus unterschiedlichen Materialien bestehen, wobei insbesondere Polymere verwendet werden.

Die Herstellung elektrischer Kontakte zwischen zwei Leitern erfolgt häufig mit Hilfe von Klebstoffen. Dabei können sowohl NCA(non-conductive adhesive)-Klebstoffe als auch ACA(anisotropically conductive adhesive)-Klebstoffe verwendet werden. Der NCA-Klebstoff ist ein nicht leitender Klebstoff, der zwei leitende Teile dauerhaft in unmittelbarem elektrischem Kontakt hält. Zur Herstellung der Verbindung werden die Kontaktflächen der Teile zusammengepresst, bis der die Kontaktflächen umgebende Klebstoff bei erhöhter Temperatur aushärtet. Der ACA-Klebstoff enthält zusätzlich kleine leitende Partikel. Diese haben einen hinreichend großen gegenseitigen Abstand, so dass der Klebstoff im unkomprimierten Zustand nicht leitet. Wird er hingegen zusammengedrückt, verringert sich der Abstand der Partikel und es entstehen leitende Brücken. Der Klebstoff kann dann ausgehärtet werden, so dass er diese leitenden Brücken zwischen den beiden Kontaktflächen dauerhaft aufrechterhält. In den Bereichen außerhalb der Kontaktflächen wird der Klebstoff nicht verdichtet, so dass er dort nichtleitend bleibt und nur eine mechanische Verbindung zwischen den Teilen herstellt.

Die elektrische Leitung derartiger Kontakte ergibt sich durch ohmsche Leitung oder den Tunneleffekt. Sie kann auch durch eine Mischung dieser beiden Effekte zustande kommen.

Die elektrische Kontaktierung zweier leitender Teile, von denen mindestens eines elektrisch isoliert ist, weist jedoch den Nachteil auf, dass entweder die Isolation vorher an der Kontaktstelle entfernt werden muss oder die Isolation an der Kontaktstelle selbst erst gar nicht aufgebracht sein darf. Dieser Verfahrensschritt, der jeweils vor der eigentlichen Kontaktierung durchgeführt werden muss, ist mit zusätzlichem Arbeitsaufwand verbunden und kann sogar zur Folge haben, dass bestimmte Verbindungen nicht in gewünschter Weise hergestellt werden können.

Es ist daher die Aufgabe der vorliegenden Erfindung, ein Verfahren zum gleichzeitigen mechanischen und elektrischen Verbinden von zwei einander nur teilweise überdeckenden, mit elektrisch leitenden Strukturen versehenen Teilen, von denen mindestens eines zur elektrischen Isolierung und/oder zum mechanischen und/oder chemischen Schutz über den Überdeckungsbereich hinaus großflächig unter Einschluss der Verbindungsfläche mit einer Schicht aus elektrisch isolierendem Material bedeckt ist, wobei die leitenden Teile im Bereich ihrer Verbindungsflächen gegeneinander gepresst werden, anzugeben, bei dem dieser zusätzliche Schritt des lokalen Entfernens der Isolation bzw. des selektiven Aufbringens der Isolation nicht erforderlich ist, so dass das Verfahren erheblich vereinfacht werden kann.

Diese Aufgabe wird erfindungsgemäß durch ein Verfahren mit den Merkmalen des Anspruchs 1 gelöst. Vorteilhafte Weiterbildungen dieses Verfahrens ergeben sich aus den Unteransprüchen.

Dadurch, dass als elektrisch isolierendes Material ein Klebstoff verwendet wird, der während des Verbindens unter Ausbildung eines elektrischen Kontakts zwischen den elektrischen Verbindungsflächen der leitenden Teile zwischen diesen und im diese umgebenden Bereich in einen klebrigen Zustand versetzt und anschließend in einen nichtklebrigen Zustand übergeführt wird, hat der Vorgang des Versetzens des Klebstoffs in den klebrigen Zustand auch zur Folge, dass er in einen fließfähigen Zustand gebracht wird, in welchem er durch das Gegeneinanderpressen aus dem Kontaktbereich herausgedrückt oder im Kontaktbereich zusammengedrückt werden kann. Im Fall einer Verwendung eines NCA-Klebstoffs wird dieser aus dem Kontaktbereich herausgedrückt, und im Falle der Verwendung eines ACA-Klebstoffs oder ICA-Klebstoffs (isotropically conductive adhesive) wird dieser zumindest zusammengedrückt, so dass in jedem Falle eine elektrische Verbindung zwischen den leitenden Teilen erhalten wird. Bei einem NCA-Klebstoff besteht die mechanische Verbindung nur außerhalb der Kontaktfläche, während sie bei einem ACA-Klebstoff oder ICA-Klebstoff auch im Bereich der Kontaktfläche vorliegt.

Da außerhalb der elektrischen Verbindungs- bzw. Kontaktfläche das Gegeneinanderpressen der leitenden Teile nicht dazu führen darf, dass das elektrisch isolierende Material in erheblichem Maße zur Seite gedrückt oder leitend wird, ist die elektrische Verbindungsfläche zumindest eines der Leiter gegenüber dem diese umgebenden Bereich erhaben, so dass, wenn die elektrischen Verbindungsflächen aneinander anliegen, noch ein eine ausreichende Isolierung bewirkender Spalt zwischen den die elektrischen Verbindungsflächen umgebenden Bereichen verbleibt. Die erhabene Verbindungsfläche kann beispielsweise ein als Stud Bump ausgebildeter Metallkontakt sein.

Das Versetzen des isolierenden Materials in den klebrigen sowie fließfähigen Zustand erfolgt vorzugsweise durch Wärmezufuhr. Wird ein wärmehärtender Klebstoff verwendet, so findet auch die Überführung in den nichtklebrigen Zustand (Aushärtung) bei erhöhter Temperatur statt. Wird ein Schmelzkleber als isolierendes Material eingesetzt, wird dieser Vorgang durch Abkühlung erreicht.

Insbesondere in diesem Fall kann das elektrisch isolierende Material, das vor dem Verbinden nichtklebrig und in einem festen Zustand ist, auf einfache Weise durch Erwärmen in einen klebrigen und fließfähigen Zustand gebracht und anschließend auf einfache Weise durch Abkühlen wieder in den nichtklebrigen und festen Zustand zurückgeführt werden.

Die Wärmezufuhr kann durch Temperaturerhöhung des umgebenden Raums, aber auch gezielt durch Einwirkung von Infrarot- oder Lichtstrahlen, Ultraschall sowie magnetische oder elektrische Felder erfolgen.

Es ist jedoch auch möglich, die Klebrigkeit und Fließfähigkeit auf chemischem Wege herbeizuführen. So kann dem isolierenden Material ein flüchtiges Lösungsmittel hinzugefügt werden, das diesen Zustand bewirkt. Nachdem der elektrische Kontakt durch Druckaufbringung hergestellt ist, verdampft das Lösungsmittel unter Aufrechterhaltung des Drucks, bis das isolierende Material sich wieder verfestigt hat.

Im Gegensatz zum bekannten NCA- oder ACA-Kleben isoliert und/oder schützt der Klebstoff mindestens eines der leitenden Teile dort, wo er nicht zur mechanischen oder elektrischen Verbindung der Teile beiträgt. Denn außerhalb der Verbindung bleibt er zumindest in seiner Funktion unverändert und erfüllt weiterhin die Funktionen eines elektrischen Isolators und/oder eines mechanischen und/oder chemischen Schutzes. Bei einem thermisch aushärtenden Klebstoff ist es jedoch auch möglich, dass der Isolator/Klebstoff insgesamt ausgehärtet wird, falls dies wünschenswert ist. Diese Aushärtung reduziert jedoch möglicherweise eine zuvor vorhandene Flexibilität eines oder beider Teile.

In einer Variante ist der Klebstoff/Isolator zunächst nicht Bestandteil eines der an der Kontaktierung beteiligten Leiter. Er ist, wie beim normalen NCA-Kleben ein separates Teil (z.B. eine Folie oder eine Paste). Im Unterschied zum NCA-Kleben bedeckt der Klebstoff nach dem Verbinden auch Bereiche eines oder beider Teile, die nicht zur elektrischen oder mechanischen Verbindung der Teile beitragen. Ziel ist hier die elektrische Isolation und/oder der mechanische und/oder der chemische Schutz des Teils oder der Teile. Der Verbindungsvorgang erfolgt wie bei einem beschichteten Leiter, jedoch wird man häufig zusätzlich den Klebstoff auch überall dort klebrig machen (und möglicherweise auch mit Andruckkraft belegen), wo dieser mit dem Leiter verbunden werden soll. Der Verbindungsvorgang ist dabei so durchzuführen, dass ein elektrischer Kontakt nur dort entsteht, wo er auch erwünscht ist, und dass die Isolation der anderen Bereiche sichergestellt wird. Dies kann z.B. mit einem Presswerkzeug umgesetzt werden, das an der Stelle, wo der Kontakt entstehen soll, erhaben ist und so an dieser Stelle einen höheren Druck aufbringt. In anderen Fällen wird allein durch die Topografie der zu verbindenden Teile (z.B. durch eine erhabene Kontaktfläche) sichergestellt werden können, dass nur die Kontaktstellen der Teile elektrisch verbunden werden.

Die wesentlichen Eigenschaften des Klebstoffs/Isolators sind somit, dass er elektrisch isoliert und/oder mechanisch und/oder chemisch schützt, und dass er durch Druck und Temperatur so verändert werden kann, dass er die Aufgabe eines NCA- oder ACA-Klebstoffs zur elektrischen Kontaktierung übernehmen kann.

In einer weiteren Variante können durch Verwendung von verschiedenen Klebstoffen gezielte bestimmte Verbindungen hergestellt und andere Verbindungen unterdrückt werden, trotz ansonsten einheitlicher großflächiger Behandlungsart. Dabei unterscheiden sich die Klebstoffe z.B. in ihrer Reaktionsart (z.B. wärmehärtend oder thermoplastisch) oder in ihrer Reaktion auf physikalische Einflüsse (z.B. Reaktion durch Licht oder Reaktion durch Wärme) oder hinsichtlich der Parameter, bei denen sie reagieren (z.B. verschiedene Reaktionstemperaturen). So können durch die Wahl der Reihenfolge der physikalischen Einflüsse oder der Parameter selektiv bestimmte Verbindungen aufeinander folgend erzeugt werden.

Beispielsweise sind in einer gewebten Fläche jeweils in Kette und Schuss ein leitender Faden mit einem ersten Klebstoff und ein leitender Faden mit einem zweiten Klebstoff als Isolator beschichtet. Der erste Klebstoff ist wärmehärtend bei 100°C und der zweite Klebstoff ist ebenfalls wärmehärtend, jedoch bei 150°C. Wird das Gewebe zwischen zwei Platten gepresst und auf 100°C erhitzt, verflüssigt sich nur der erste Klebstoff und härtet nach einiger Zeit aus, so dass nur die leitenden Fäden mit dem ersten Klebstoff miteinander kontaktiert werden. Anschließend wird die Temperatur der Pressplatten auf 150°C erhöht. Der erste Klebstoff ist bereits ausgehärtet und erweicht nicht mehr. Der zweite Klebstoff hingegen verflüssigt sich, härtet aus und verbindet so nur die leitenden Fäden, die mit dem zweiten Klebstoff beschichtet sind. Ähnliches ist erzielbar mit einer Kombination aus lichtempfindlichen Klebstoffen oder Klebstoffen, die auf Ultraschall reagieren.

Bei dieser Variante sind ein Werkzeug mit Erhebungen oder eine spezielle Topografie der zu verbindenden Teile nicht erforderlich, obwohl diese natürlich dennoch eingesetzt werden können, um den Druck an den Kontaktstellen zu erhöhen.

Der Begriff "leitendes Teil" ist nicht auf Drähte oder Kabel beschränkt, sondern gemeint ist alles, was die Funktion des elektrischen Leitens übernehmen kann, wie beispielsweise Leiter auf Leiterplatten, leitfähige Bänder, Kabelbänder, leitfähige Fäden aller Art, textile leitfähige Flächen, textile Flächen mit leitfähigen Strukturen und dergleichen.

Leitfähige Fäden sind elektrische Leiter mit Faden-, Garn- oder Fasercharakter, wie z.B. beschichtete Fasern oder metallische Fasern oder Garne bestehend aus nichtleitfähigen und leitfähigen Fasern und/oder Drähten.

Textile Flächen können vollständig leitend sein oder teilweise leitende Strukturen aufweisen, die vollständig oder teilweise isoliert sind. Textile Flächen können beispielsweise aus leitenden textilen Fäden durch Weben, Stricken oder Besticken oder auch durch leitfähige Beschichtungen auf textilen Flächen hergestellt sein. Es sei erwähnt, dass auch Vliese als textile Flächen verstanden werden sollen, auch wenn diese streng genommen nicht als Textilien bezeichnet werden.

Eine spezielle Anwendung kann für Anzeige- oder Beleuchtungszwecke erfolgen. Hierbei sind zwischen zwei vollständig oder strukturiert leitfähigen textilen oder nicht textilen Flächen zweiseitig kontaktierbare lichtemittierende Bauelemente (z.B. LEDs) angeordnet, wobei die beiden Flächen und die lichtemittierenden Bauelemente mit einem isolierenden Material (Klebstoff) zusammenklebt werden. Dabei hält dieser Klebstoff die Kontakte des lichtemittierenden Bauelements in elektrischem Kontakt mit jeweils einer der beiden Flächen und isoliert gleichzeitig diese Flächen voneinander. Der Klebstoff kann dabei vollflächig auf eine oder auf beide Flächen aufgebracht sein, aber auch als separates Teil (z.B. als Film, Pulver, Paste, Spray usw.) zwischen die Flächen gebracht werden.

Jedoch können auch einseitig kontaktierbare LEDs auf nur einer strukturiert leitfähigen textilen oder nicht textilen Fläche angeordnet werden.

Der Klebstoff kann aber auch anstatt auf die gesamte Fläche auf einzelne textile oder nichttextile Leiter aufgebracht sein, die sich auf oder in der Fläche befinden.

Hat das lichtemittierende Bauelement mehr als zwei Anschlüsse (z.B. RGB-LEDs), die somit auch mehrere Kontakte mit mindestens einer der beiden Flächen aufweisen, werden vorzugsweise textile Flächen verwendet, die strukturierte Leiter aufweisen, um die einzelnen Anschlüsse selektiv zu versorgen.

Anstelle der lichtemittierenden Bauelemente können auch Sensoren aller Art wie Beschleunigungssensoren, Temperatursensoren, Thermoelemente, Feuchtesensoren, Lichtsensoren usw., Aktuatoren aller Art wie Vibratoren, Heizelemente, Piezoelemente usw., elektronische Module aller Art oder Antennen aller Art in der beschriebenen Weise kontaktiert werden.

Das großflächig mit der Schicht aus elektrisch isolierendem Material bedeckte, elektrisch leitende Teil kann auch ein mit von der Schicht aus elektrisch isolierendem Material bedeckten Leiterbahnen versehenes Halbleitersubstrat sein, wobei die mechanische und elektrische Verbindung zwischen diesem und mindestens einem Flip-Chip und/oder mindestens einem passiven Bauteil hergestellt werden soll. Dabei verlaufen die Leiterbahnen zumindest teilweise außerhalb des Überdeckungsbereichs der zu verbindenden Teile.

Die Erfindung wird im Folgenden anhand von in den Figuren dargestellten Ausführungsbeispielen näher erläutert. Es zeigen:
- Fig. 1: ein Flachbandkabel bzw. Leiterband und ein flaches Substrat mit Kontaktflächen einerseits vor und andererseits nach ihrer gegenseitigen Verbindung,
- Fig. 2: eine zwischen zwei textilen Flächen eingebettete Leuchtdiode (LED), und
- Fig. 3: die Draufsicht auf ein mit Leiterbahnen versehenes Substrat und einen senkrechten Querschnitt durch dieses entlang der Linie A-A.

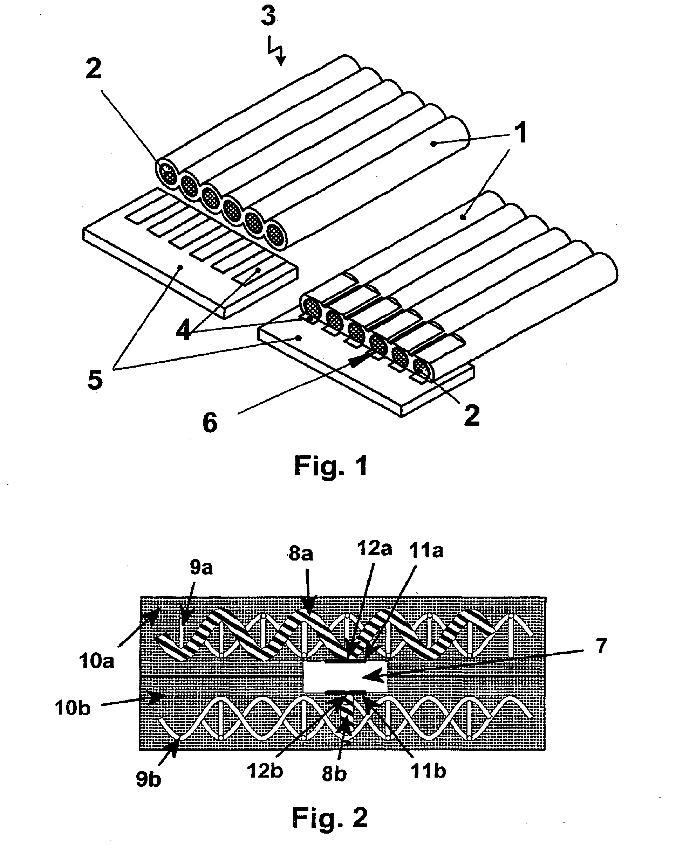

In Fig. 1 sind auf der linken Seite ein aus mehreren parallelen, mit jeweils einer Isolierschicht 1 überzogenen Leitern 2 bestehendes Flachbandkabel 3 sowie ein mit Kontaktflächen 4 versehenes, flaches Substrat 5 getrennt dargestellt. Die runden Leiter 2 haben den gleichen gegenseitigen Abstand wie die Kontaktflächen 4 auf dem Substrat 5.

Um die auf der rechten Seite von Fig. 1 dargestellte elektrische und mechanische Verbindung zwischen dem Flachbandkabel 3 und dem Substrat 5 zu erhalten, wurde zumindest der vordere Bereich des Flachbandkabels 3, der mit dem Substrat 5 überlappt, so erwärmt, dass der entsprechende Bereich der Isolierschicht 1 klebrig und fließfähig wurde. Dieser Bereich wurde dann von oben gegen den die Kontaktflächen 4 aufweisenden Bereich des Substrats 5 gedrückt, wobei jeweils einem Leiter 2 eine Kontaktfläche 4 gegenüberlag. Die Isolierschicht 1 wurde dabei je nach Art ihrer Beschaffenheit (entweder NCA oder ACA) zwischen einem Leiter 2 und der zugehörigen Kontaktfläche 4 zur Seite gedrückt oder zusammengedrückt, wodurch eine für den jeweiligen Verwendungszweck ausreichende elektrische Verbindung 6 zwischen diesen hergestellt und zwischen den Kontaktflächen 4 die Isolierschicht 1 ganzflächig gegen das Substrat 5 gedrückt wurde. Durch nachfolgendes Aushärten oder Erstarren der wärmebehandelten Bereiche der Isolierschicht 1 wurde eine feste mechanische Verbindung zwischen dem Substrat 5 und dem Flachbandkabel 3 erhalten, die auch die elektrischen Verbindungen 6 dauerhaft aufrecht erhält.

Fig. 2 zeigt eine zwischen zwei Gewebeschichten eingebettete LED 7. Die obere Gewebeschicht besteht aus einem fadenförmigen Leiter 8a, der in der Zeichnungsebene (z.B. Webschuss) verläuft, sowie nichtleitenden textilen Fäden 9, die sowohl in der Zeichnungsebene als auch senkrecht zu dieser (z.B. Webkette) verlaufen. Das Gewebe ist in eine Schicht 10 aus isolierendem Material/Klebstoff eingebettet. In gleicher Weise besteht die untere Gewebeschicht aus einem fadenförmigen Leiter 8b, der senkrecht zur Zeichnungsebene verläuft, sowie nichtleitenden textilen Fäden 9b, die in eine Schicht 10b aus isolierendem Material/Klebstoff eingebettet sind. Der zueinander senkrechte Verlauf der Leiter 8a und 8b ermöglicht die selektive Ansteuerung von zwischen den Gewebeschichten matrixförmig angeordneten LEDs. Die Schichten 10a und 10b sind lichtdurchlässig, so dass eine leuchtende LED von außen sichtbar ist.

Auf der oberen und der unteren Fläche der LED 7 befindet sich jeweils ein Anschlusskontakt 11a bzw. 11b. Werden die Gewebeschichten flächig erwärmt und zusammengedrückt, verkleben die Schichten 10a und 10b außerhalb der LEDs miteinander. Der Leiter 8a und der Anschlusskontakt 11a einerseits und der Leiter 8b und der Anschlusskontakt 11b andererseits werden gegeneinander gedrückt, so dass sich ein elektrischer Kontakt 12a bzw. 12b zwischen ihnen ausbildet. Außerhalb der Kontaktflächen verklebt auch die LED 7 mit den Schichten 10a und 10b. Nach dem Aushärten bzw. Erstarren der Schichten 10a und 10b erhält man eine stabile Matrix aus LEDs, die in gewünschter Weise mit fadenförmigen Leitern so kontaktiert sind, dass sie selektiv angesteuert werden können.

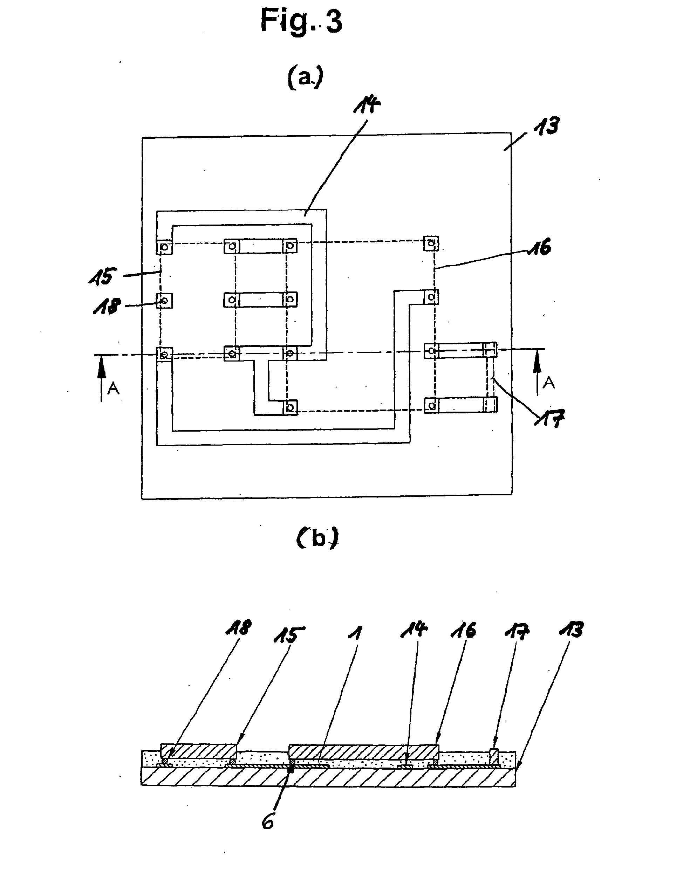

Fig. 3(a) zeigt die Draufsicht auf ein Substrat 13, z.B. ein Flexsubstrat oder ein FR4 Substrat, das auf der oberen Seite Leiterbahnen 14 trägt. Diese Seite ist vollflächig einschließlich der Leiterbahnen 14 mit einer Schicht aus elektrisch isolierendem Material 1 bedeckt. Diese Schicht wurde nach der Ausbildung der Leiterbahnen 14 auf das Substrat 13 aufgebracht, um die Substratoberfläche einschließlich der Leiterbahnen 14 elektrisch zu isolieren und gegen mechanische Einwirkungen zu schützen.

Um das Substrat 13 mit Flip-Chips 15 und 16 sowie einem passiven Bauteil 17 mechanisch und elektrisch zu verbinden, wird das elektrisch isolierende Material 1 zunächst beispielsweise durch Erwärmen in einem klebrigen und fließfähigen Zustand gebracht. Die Flip-Chips 15 und 16 sowie das Bauteil 17 werden dann mit ihrer Kontakte 18 tragenden Seite lagerichtig gegen die Oberseite des Substrats 13 gedrückt, so dass die vorstehenden Kontakte 18 das isolierende Material 1, wenn es ein NCA-Klebstoff ist, beiseite drängen und in unmittelbaren Kontakt mit einer Leiterbahn gelangen, oder, wenn es ein ACA-Klebstoff ist, so zusammendrücken, dass es zwischen den Kontakten 18 und den Leiterbahnen 14 elektrisch leitend wird und in den übrigen Bereichen isolierend bleibt.

In diesem Zustand wird das Material 1 beispielsweise durch Abkühlen wieder in seinen vorherigen, mechanisch stabilen Zustand gebracht, wobei das Substrat 13 einerseits und die Flip-Chips 15 und 16 sowie das Bauelement 17 mechanisch dauerhaft verbunden bleiben, wodurch auch die elektrische Verbindung 6 zwischen den Kontakten 18 und den Leiterbahnen 14 dauerhaft verbunden bleibt. Das Substrat 13 und die Leiterbahnen 14 sind vollflächig, d.h. auch außerhalb der Überdeckungsbereiche mit den Flip-Chips 15 und 16 sowie dem Bauelement 17 durch das Material 1 dauerhaft elektrisch isoliert und mechanisch geschützt. Zwischen dem Substrat 13 und den Flip-Chips 15 bzw. 16 verlaufende Bereiche der Leiterbahnen 14, denen keine Kontakte 18 gegenüberliegen, sind ebenfalls durch das Material 1 isoliert und geschützt.

Neben dem in dieser Erfindung ganz allgemein definierten Isolator/Klebstoff Material hat sich im Speziellen thermoplastisches Polyurethan als NCA Kleber und Isolator als geeignet herausgestellt.

## Patentansprüche

1. Verfahren zum gleichzeitigen mechanischen und elektrischen Verbinden von zwei einander nur teilweise überdeckenden, mit elektrisch leitenden Strukturen versehenen Teilen (2,4; 8,11; 13, 15, 16, 17), von denen mindestens eines zur elektrischen Isolierung und/oder zum mechanischen und/oder chemischen Schutz über den Überdeckungsbereich hinaus großflächig unter Einschluss der Verbindungsfläche mit einer Schicht aus elektrisch isolierendem Material (1; 10) bedeckt ist, wobei die leitenden Teile (2, 4; 8, 11; 13, 15, 16, 17) im Bereich ihrer Verbindungsflächen gegeneinander gepresst werden, **dadurch gekennzeichnet, dass** als elektrisch isolierendes Material (1; 10) ein Klebstoff verwendet wird, der während des Verbindens unter Ausbildung eines elektrischen Kontakts (6; 12) zwischen den elektrischen Verbindungsflächen der elektrisch leitenden Teile (2, 4; 8, 11; 13, 15, 16, 17) zwischen diesen und im diese umgebenden Bereich in einen klebrigen und fließfähigen Zustand versetzt und anschließend in einen dauerhaft haftenden Zustand übergeführt wird, um den elektrischen Kontakt der Verbindung aufrechtzuerhalten.

2. Verfahren nach Anspruch 1, **dadurch gekennzeichnet, dass** die Schicht aus elektrisch isolierendem Material (1; 10) vor dem Verbinden in einem mechanisch stabilen Zustand ist und für das Verbinden in einem klebrigen und fließfähigen Zustand übergeführt wird.

3. Verfahren nach Anspruch 1 oder 2, **dadurch gekennzeichnet, dass** das Versetzen des isolierenden Materials (1; 10) in den klebrigen und fließfähigen Zustand durch Zuführung von Energie zu dem isolierenden Material (1; 10) oder durch chemische Behandlung erfolgt, und/oder dass das Überführen des isolierenden Materials (1; 10) aus dem klebrigen und fließfähigen Zustand in den dauerhaft haftenden Zustand durch Abkühlen oder durch Verdampfen eines dem isolierenden Material (1; 10) beigesetzten flächigen Lösungsmittels erfolgt.

4. Verfahren nach einem der Ansprüche 1 bis 3, **dadurch gekennzeichnet, dass** das isolierende Material (1; 10) ein Schmelzkleber oder ein wärmehärtender Klebstoff ist.

5. Verfahren nach Anspruch 4, **dadurch gekennzeichnet, dass** das isolierende Material (1; 10) aus Polyurethan besteht.

6. Verfahren nach einem der Ansprüche 1 bis 5, **dadurch gekennzeichnet, dass** das isolierende Material (1; 10) als separates Teil und/oder in Form einer Folie oder Paste auf mindestens eines der elektrisch leitenden Teile (2; 8) aufgebracht ist.

7. Verfahren nach einem der Ansprüche 1 bis 6, **dadurch gekennzeichnet, dass** das isolierende Material (1; 10) im klebrigen und fließfähigen Zustand durch das Gegeneinanderpressen der elektrischen Verbindungsflächen der beiden Teile (2, 4; 8, 11) als mit leitenden Partikeln versetzter Klebstoff zusammengedrückt oder als nicht leitender Klebstoff aus der elektrischen Verbindungsfläche herausgedrückt wird, und dann das isolierende Material (1; 10) in den dauerhaft haftenden Zustand übergeführt wird.

8. Verfahren nach einem der Ansprüche 1 bis 5, **dadurch gekennzeichnet, dass** die elektrische Verbindungsfläche zumindest eines der Leiter (2, 4; 8, 11) gegenüber dem diese umgebenden Bereich erhaben und/oder ein als Stud Bump ausgebildeter Metallkontakt ist.

9. Verfahren nach einem der Ansprüche 1 bis 8, **dadurch gekennzeichnet, dass** für verschiedene, selektiv herzustellende Verbindungen zwischen mindestens zwei Teilen unterschiedliche Klebstoffe (1; 10) verwendet werden.

10. Verfahren nach einem der Ansprüche 1 bis 9, **dadurch gekennzeichnet, dass** zumindest eines der leitenden Teile ein mit dem Klebstoff isoliertes Kabel oder Kabelband (3), ein mit dem Klebstoff isolierter leitfähiger Faden (8), Draht oder Litze, oder ein auf einer textilen Schicht oder Vliesstoff-Schicht angeordneter oder in diese eingebetteter leitfähiger Faden (8), Draht oder Litze ist.

11. Verfahren nach Anspruch 10, **dadurch gekennzeichnet, dass** der Faden (8) aus elektrisch leitenden Fasern oder aus einem Garn bestehend aus elektrisch leitenden und nicht leitenden Fasern gebildet ist.

12. Verfahren nach einem der Ansprüche 1 bis 11, **dadurch gekennzeichnet, dass** eines der leitenden Teile ein Anschlusskontakt (11) eines lichtemittierenden Bauelements (7), das auf mindestens einer Seite ganzflächig oder teilweise mit einer leitfähigen Schicht versehen ist, ein Anschlusskontakt eines Sensors oder Aktuators, oder ein Anschlusskontakt einer Antennenanordnung ist.

13. Verfahren nach einem der Ansprüche 1 bis 9, **dadurch gekennzeichnet, dass** das großflächig mit der Schicht aus elektrisch isolierendem Material (1) bedeckte, elektrisch leitende Teil ein mit von der Schicht aus elektrisch isolierendem Material (1) bedeckten Leiterbahnen (14) versehenes Substrat (13) ist, und dass die mechanische und elektrische Verbindung zwischen dem Substrat (13) und mindestens einem auf dieses aufzubringenden Flip-Chip (15, 16) und/oder mindestens einem auf dieses aufzubringenden passiven Bauteil (17) hergestellt wird, wobei die Leiterbahnen (14) zumindest teilweise außerhalb des Überdeckungsbereichs zwischen dem Substrat (13) und den Flip-Chips (15, 16) oder passiven Bauteilen (17) verlaufen.

14. Verfahren nach einem der Ansprüche 1 bis 9, **dadurch gekennzeichnet, dass** die elektrisch leitenden Teile einander kreuzende Leiter sind.

15. Verbindung zwischen zwei elektrisch leitenden, einander nur teilweise überdeckenden Teilen, von denen zumindest das eine zur elektrischen Isolierung und/oder zum mechanischen und/oder chemischen Schutz über den Überdeckungsbereich hinaus großflächig mit einer Schicht aus elektrisch isolierendem Material bedeckt ist, **dadurch gekennzeichnet, dass** das isolierende Material ein Klebstoff ist, der die elektrisch leitenden Teile im Überdeckungsbereich mechanisch zusammenhält.

## Claims

1. Method for the simultaneous mechanical and electrical connection of two parts (2, 4; 8, 11; 13, 15, 16, 17), which cover each other only partially and are provided with electrically conducting structures, at least one of which parts, for electrical insulation and/or for mechanical and/or chemical protection, is covered beyond the overlapping region over a large area including the connection surface with a layer made of electrically insulating material (1; 10), the conducting parts (2, 4; 8, 11; 13, 15, 16, 17) being pressed together in the region of their connection surfaces,
**characterised in that**
an adhesive is used as electrically insulating material (1; 10) which is changed into a tacky and flowable state during the connection, whilst forming an electrical contact (6; 12) between the electrical connection surfaces of the electrically conducting parts (2, 4; 8, 11; 13, 15, 16, 17), between these and in the region surrounding these, and subsequently is converted into a permanently adhesive state in order to maintain the electrical contact of the connection.

2. Method according to claim 1, **characterised in that** the layer made of electrically insulating material (1; 10) is in a mechanically stable state before the connection and is converted into a tacky and flowable state for the connection.

3. Method according to claim 1 or 2, **characterised in that** changing the insulating material (1; 10) into the tacky and flowable state is effected by supplying energy to the insulating material (1; 10) or by chemical treatment, and / or that converting the insulating material (1; 10) from the tacky and flowable state into the permanently adhesive state is effected by cooling or by evaporating of a volatile solvent added to the insulating material (1; 10).

4. Method according to one of the claims 1 to 3, **characterised in that** the insulating material (1; 10) is a hot-melt adhesive or a heat-hardening adhesive.

5. Method according to claim 4, **characterised in that** the insulating material (1; 10) consists of polyurethane.

6. Method according to one of the claims 1 to 5, **characterised in that** the insulating material (1; 10) is applied as separate part and / or as film or paste on at least one of the electrically conducting parts (2; 8).

7. Method according to one of the claims 1 to 6, **characterised in that** the insulating material (1; 10) is compressed in the tacky and flowable state by the pressing-together of the electrical connection surfaces of the two parts (2, 4; 8, 11) as an adhesive which is mixed with conductive particles or is pressed out of the electrical connection surface as a non-conducting adhesive, and then the insulating material (1; 10) is converted into the permanently adhesive state.

8. Method according to one of the claims 1 to 5, **characterised in that** the electrical connection surface at least of one of the conductors (2, 4; 8, 11) is raised relative to the region surrounding it, and / or is a metal contact configured as a stud bump.

9. Method according to one of the claims 1 to 8, **characterised in that** different adhesives (1; 10) are used for different connections to be produced selectively between at least two parts.

10. Method according to one of the claims 1 to 9, **characterised in that** at least one of the conducting parts is a cable or cable strip (3) insulated with the adhesive, a conductive thread (8), wire or flex insulated with the adhesive, or a thread (8), wire or flex which is disposed on a textile layer or nonwoven layer or embedded in this.

11. Method according to claim 10, **characterised in that** the thread (8) is formed from electrically conducting fibres or from a yarn consisting of electrically conducting and non-conducting fibres.

12. Method according to one of the claims 1 to 11, **characterised in that** one of the conducting parts is a terminal contact (11) of a lightemitting component (7) which is provided on at least one side over the entire surface or partially with a conductive layer, a terminal contact of a sensor or actuator, or a terminal contact of an antenna arrangement.

13. Method according to one of the claims 1 to 9, **characterised in that** the electrically conducting part which is covered over a large area with the layer made of electrically insulating material (1) is a substrate (13) which is provided with strip conductors (14) covered by the layer made of electrically insulating material (1), and that the mechanical and electrical connection is produced between the substrate (13) and at least one flip-chip (15, 16) to be applied on this and / or at least one passive component (17) to be applied on this, wherein the strip conductors (14) extend at least partially outside the overlapping region between the substrate (13) and the flip-chips (15, 16) or passive components (17).

14. Method according to one of the claims 1 to 9, **characterised in that** the electrically conducting parts are intersecting conductors.

15. Connection between two electrically conducting parts which cover each other only partially and at least the one of which, for electrical insulation and/or for mechanical and/or chemical protection, is covered beyond the overlapping region over a large area with a layer made of electrically insulating material, **characterised in that** the insulating material is an adhesive which holds the electrically conducting parts together mechanically in the overlapping region.

## Revendications

1. Procédé de liaison mécanique et électrique simultanée de deux pièces (2, 4 ; 8, 11 ; 13, 15, 16, 17) ne se recouvrant que partiellement l'une l'autre, pourvues de structures électriquement conductrices, dont au moins l'une est recouverte, pour l'isolation électrique et/ou la protection mécanique et/ou chimique, en plus de la zone de recouvrement, sur une grande surface avec inclusion de la surface de liaison, d'une couche fabriquée en un matériau électriquement isolant (1 ; 10), les pièces conductrices (2, 4 ; 8, 11 ; 13, 15, 16, 17) étant pressées l'une contre l'autre dans la zone de leurs surfaces de liaison, **caractérisé en ce qu'**on utilise en tant que matériau électriquement isolant (1 ; 10) un adhésif qui, pendant la liaison, passe à un état collant et liquide avec formation d'un contact électrique (6 ; 12) entre les surfaces de liaison électriques des pièces électriquement conductrices (2, 4 ; 8, 11 ; 13, 15, 16, 17), entre ces dernières et dans cette zone qui les entoure, puis passe à un état adhésif permanent, pour maintenir le contact électrique de la liaison.

2. Procédé selon la revendication 1, **caractérisé en ce que** la couche fabriquée en un matériau électriquement isolant (1 ; 10) se trouve avant la liaison dans un état mécaniquement stable et, pour assurer la liaison, est passé à un état collant et liquide.

3. Procédé selon la revendication 1 ou 2, **caractérisé en ce que** le passage du matériau isolant (1 ; 10) à l'état collant et liquide s'effectue par apport d'énergie au matériau isolant (1 ; 10) ou par un traitement chimique, et/ou que le passage du matériau isolant (1; 10) de l'état collant et fluide à l'état adhésif permanent s'effectue par refroidissement ou par évaporation d'un solvant superficiel placé contre le matériau isolant (1 ; 10).

4. Procédé selon l'une quelconque des revendications 1 à 3, **caractérisé en ce que** le matériau isolant (1 ; 10) est un adhésif thermofusible ou un adhésif thermodurcissable.

5. Procédé selon la revendication 4, **caractérisé en ce que** le matériau isolant (1 ; 10) est constitué de polyuréthane.

6. Procédé selon l'une quelconque des revendications 1 à 5, **caractérisé en ce que** le matériau isolant (1 ; 10) est appliqué en tant que pièce distincte et/ou sous forme d'une feuille ou d'une pâte sur au moins l'une des pièces électriquement conductrices (2 ; 8).

7. Procédé selon l'une quelconque des revendications 1 à 6, **caractérisé en ce que** le matériau isolant (1 ; 10) est, à l'état collant et liquide, comprimé du fait de la pression, l'une contre l'autre, des surfaces de liaison électrique des deux pièces (2, 4 ; 8, 11) sous forme d'un adhésif additionné de particules conductrices, ou, sous forme d'un adhésif non conducteur, est extrait par pression de la surface de liaison électrique, puis le matériau isolant (1 ; 10) est passé à l'état adhésif permanent.

8. Procédé selon l'une quelconque des revendications 1 à 5, **caractérisé en ce que** la surface de liaison électrique d'au moins l'un des conducteurs (2, 4 ; 8, 11) est en saillie par rapport à la zone qui entoure ces derniers, et/ou est un contact métallique configuré comme des billes de micro-connexion Stud Bump.

9. Procédé selon l'une quelconque des revendications 1 à 8, **caractérisé en ce que**, pour différentes liaisons devant être sélectivement réalisées entre au moins deux pièces, on utilise des adhésifs (1 ; 10) différents.

10. Procédé selon l'une quelconque des revendications 1 à 9, **caractérisé en ce qu'**au moins l'une des pièces conductrices est un câble ou un ruban pour câble (3), un fil (8), un fil métallique ou un cordon conducteur isolé par l'adhésif, ou un fil (8), un fil métallique ou un cordon conducteur, disposé sur une couche textile ou une couche de textile non-tissé ou enrobé dans cette dernière.

11. Procédé selon la revendication 10, **caractérisé en ce que** le fil (8) est formé à partir de fibres électriquement conductrices ou d'un filé se composant de fibres électriquement conductrices et non conductrices.

12. Procédé selon l'une quelconque des revendications 1 à 11, **caractérisé en ce que** l'une des pièces conductrices est un contact de connexion (11) d'un composant électroluminescent (7), qui est pourvu sur toute la surface ou partiellement, sur au moins une face, d'une couche conductrice, un contact de connexion d'un capteur ou d'un vérin, ou un contact de connexion d'un arrangement d'antenne.

13. Procédé selon l'une quelconque des revendications 1 à 9, **caractérisé en ce que** la pièce conductrice de l'électricité, recouverte sur une grande surface de la couche en un matériau électriquement isolant, est un substrat (13), pourvu de pistes conductrices (14) recouvertes de la couche en un matériau électriquement isolant (1), et **en ce que** la liaison mécanique et électrique est réalisée entre le substrat (13) et au moins une puce retournée (*Flip-Chip*) (15, 16) devant être appliquée sur ce dernier et/ou au moins un composant passif (17) devant être appliqué sur ce dernier, les pistes conductrices (14) s'étendant au moins partiellement à l'extérieur de la zone de recouvrement entre le substrat (13) et les puces retournées (15, 16) ou les composants passifs (17).

14. Procédé selon l'une quelconque des revendications 1 à 9, **caractérisé en ce que** les pièces électriquement conductrices sont des conducteurs qui se croisent l'un l'autre.

15. Liaison entre deux pièces électriquement conductrices, qui ne se recouvrent l'une l'autre que partiellement, dont au moins l'une est, pour l'isolation électrique et/ou la protection mécanique et/ou chimique, recouverte sur une grande surface, en plus de la zone de recouvrement, d'une couche en un matériau électriquement isolant, **caractérisée en ce que** le matériau isolant est un adhésif, qui maintient mécaniquement les pièces électriquement conductrices dans la zone de recouvrement.
